# EUROPEAN PATENT APPLICATION

(11) **EP 4 721 974 A1**
(43) Date of publication of application: **08.04.2026**
(21) Application number: 24204368.5
(22) Date of filing: 02.10.2024
(51) Int. Cl.: B32B 15/14, B32B 5/02, B32B 7/12, B32B 15/20, B64D 45/02

(54) **METHOD FOR BONDING A CONDUCTIVE LAYER TO A SUBSTRATE**

(71) Applicant: Airbus (S.A.S.), 31700 Blagnac (FR); NanoWired GmbH, 64579 Gernsheim (DE)
(72) Inventor: MEER, Thomas, 31700 Blagnac (FR); FRIEDBERGER, Alois, 31700 Blagnac (FR); HELWIG, Andreas, 31700 Blagnac (FR); BEIER, Uwe, 31700 Blagnac (FR); FRASCH, Markus, 31700 Blagnac (FR); BIRLEM, Olav, 64579 Gernsheim (DE)
(74) Representative: LKGLOBAL Partnerschaftsgesellschaft mbB

(57) **Abstract**

The present invention relates to a method for bonding a conductive member to a substrate providing a conductive path in aircraft components. The method comprises providing a substrate comprising a top layer with a primary conductive member, providing a secondary conductive member on the top layer, providing a surface structured layer between the primary conductive member and the secondary conductive member, bonding the secondary conductive member to the top layer by means of the surface structured layer to conductively couple the primary conductive member and the secondary conductive member. Also disclosed is a conductive component comprising materially and conductively bonded primary and secondary conductive members.

## Description

The present invention relates to areal surface bonding in a material stack, in particular a material stack comprising a composite material, a conductive layer and a conductive foil patch.

### TECHNICAL BACKGROUND

Attaching a layer with increased conductivity, e.g., a conductive foil, to composite materials and also attaching additional conductive patches to the conductive layer respectively the composite material, in particular for providing a sufficiently conductive path for aeronautic applications involves a complex interplay of materials science, engineering, and environmental considerations. Surface preparation, thermal expansion mismatch, environmental factors, and mechanical stress are significant obstacles that can limit the effectiveness and durability of the conductive layer. Specifically, integrating a copper mesh on composite materials and further bonding an additional conductive patch can further complicate the process, requiring careful attention to adhesion, electrical continuity, and weight management.

An aeronautic vehicle can be made out of composite materials. A conductive layer, e.g., an expanded copper foil (ECF), is commonly applied to the outer side of the composite structure. This can serve for lightning strike protection as the specific electrical conductivity of composite materials alone can be too low. Thereto, the conductive layer can provide an increased electrical conductivity to the composite material it is applied to. Additionally, the conductive layer can provide radiofrequency shielding and/or electromagnetic interference shielding. Thereto, shielding applications can comprise protecting electronic devices from electromagnetic interference, which can disrupt or degrade the performance of electronic circuits. The conductive layer can reflect or absorb radio waves. The conductive layer can be embedded in the resin of the composite part or applied to the composite part using an adhesive. In areas where electrical systems are intended to be installed, an additional conductive layer, e.g., a continuous copper foil patch, can be attached to the conductive layer providing an area with increased conductivity, e.g., realizing increased shielding. This approach can also be used to connect several composite parts to each other, ensuring that the entire structure has a continuous conductive path. The conductive layer can be conductively connected to the additional conductive patch.

A conventional bonding preparation involving solvent cleaning and sanding may not achieve a sufficient joining strength to reliable bond the conductive patch to the conductive layer, respectively the composite material. Thus, it is an object of the present invention to provide an extensive areal bond between the conductive layer on the composite material and an additional conductive patch with increased bonding durability, specifically with increased peel strength.

Aspects of the invention can achieve the advantage of substantially improving the adhesion between epoxy composite materials, the conductive layer and/or the additional conductive element. Specifically, the integrity and robustness of the electrical contact between the conductive layer and the additional conductive patch can be increased.

### SUMMARY

The objective addressed by the present invention is to provide an improved method for bonding a conductive layer to a substrate, specifically a composite material to increase bonding strength and durability.

Disclosed herein are a composite component with increased conductivity and a corresponding method for manufacturing the composite component. A bonding strength and durability of a primary conductive member, e.g., an ECF, being attached to a composite substrate can be increased by providing a surface structured layer on the primary conductive member. Additionally or alternatively, the bond of a secondary conductive member, such as a copper foil patch, can be enhanced by providing a surface structure on at least one bonding surface of the secondary conductive member with which it is attached to the composite material, or alternatively, the primary conductive member.

According to a first aspect the present invention relates to a method for bonding a conductive member to a substrate providing a conductive path for aircrafts, preferably in structural aircraft components. The method can comprise the step of providing a substrate comprising a top layer with a primary conductive member, in particular positioned at a top surface of the top layer. Further, the method can comprise providing a secondary conductive member on the top layer and providing a surface structured layer between the primary conductive member and the secondary conductive member. The method can comprise bonding the secondary conductive member to the top layer by means of the surface structured layer to conductively couple the primary conductive member and the secondary conductive member.

The method can be extended to various composite manufacturing processes beyond those using pre-impregnated (prepreg) material. Other manufacturing processes include Automated Fiber Placement (AFP), Automated Tape Laying (ATL), Resin Transfer Molding (RTM), and filament winding. AFP and ATL are advanced techniques where fibers or tapes are precisely placed onto a mold, allowing for complex shapes and high precision. RTM involves injecting resin into a mold containing dry fibers, which then cures to form the composite. Filament winding is a process where continuous fibers are wound under tension over a rotating mandrel, creating hollow, cylindrical structures. Each of these methods offers unique advantages and can be optimized using features of the disclosed method, enhancing efficiency and material properties in composite manufacturing.

Surface treatments and coatings can significantly enhance adhesion, corrosion resistance, and durability in particular in combination with composite substrates comprising epoxy. These coatings can be configured to create a uniform layer that enhances the interface compatibility between the conductive member and the composite material.

The substrate can be a composite, e.g., carbon fibre and/or glass fibre reinforced plastics (CFRP, GFRP). The substrate can have a sheet like form having a substantially larger area compared to its thickness. Furthermore, the substrate can be a structural element, hull segment, cabinet segment, compartment segment, and/or constructive element. Specifically, the substrate can be configured for use in an airplane.

The substrate can be planar or curved. Further, the substrate can have a complex form. Preferably, the substrate and the secondary conductive member can provide a form fit connection such that the secondary conductive member follows the profile, topography, and/or surface design of the substrate. Also, the primary conductive member can be formed according to the shape of the substrate and/or secondary conductive member.

The primary conductive member can be integrated in the substrate such that the primary conductive member forms the top surface of the substrate. Alternatively, the primary conductive member can be embedded in the top layer, preferably near the top surface, such that the secondary conductive member can electrically connect to the primary conductive member during the bonding process. The top layer can be an intermediary layer between the substrate, the primary conductive member, and the secondary conductive member.

The primary conductive member can be a conductive sheet, e.g., a conductive foil, preferably a metal foil, more preferably a copper foil. The method can comprise extending the primary conductive member to form an extended conductive foil before applying or embedding the primary conductive member in the top layer. The primary conductive member can be configured to provide electromagnetic interference (EMI) and/or radio frequency interference (RFI) shielding. The primary conductive member can additionally or alternatively be configured to provide lightning protection. Thereto, the primary conductive member can provide a low resistance path for a lightning current to travel. Specifically, the primary conductive member can be configured to allow a high-voltage current to flow through it. This can achieve the advantage of minimizing potential damage to the underlying composite material. Additionally, the lightning current can be distributed over a larger area reducing the risk of localized heating and damage. Providing a continuous path can further decrease the risk of delamination and/or other structural failures in the composite material. The conductive layer can be integrated with a grounding system. Further, the primary conductive member can be configured to increase the thermal conductivity of the composite of substrate and primary conductive member. This can achieve the advantage of increasing the integrity of the composite under varying thermal conditions.

The primary conductive member can be soft, malleable, and/or ductile when being extended to a mesh. Thereby, the primary conductive member can adjust to the shape of the substrate. The primary conductive member can be formed according to the topography of the top surface of the substrate while maintaining its mechanical properties and structural integrity. Meshing of the primary conductive member can be achieved by a slit and stretch process creating a network of interconnected strands. Before integration into or onto the substrate, the primary conductive member can be surface treated to enhance its bonding with the substrate, i.e., the composite material. This can include cleaning, etching, and/or applying a primer to improve adhesion. Preferably, the method can comprise growing nanostructures on the surface of the primary conductive member. These nanostructures can improve the bonding between the primary conductive member and top layer, respectively the substrate. Specifically, the bonding of a resin of the substrate and the primary conductive member. Thereto, applying the primary conductive member to the substrate can be performed before the top layer is cured.

Integrating the primary conductive member into the top layer can be performed during a lay-up process. Thereto, the method can comprise disposing the primary conductive member between layers of composite material, e.g., carbon fiber prepreg, in the desired configuration. Once the lay-up is complete, the composite material, including the embedded copper mesh, can be subjected to a curing process. This can involve applying heat and/or pressure to solidify the resin and bond the layers together.

Bonding a material stack comprising any combination of the substrate, top layer, primary conductive member, secondary conductive member, and/or outer layer can comprise applying pressure to the material stack. Thereto, the method can comprise pressing the material stack, e.g., by mechanically pressing the material stack on a tooling platform. Pressing can comprise applying a pressure by means of vacuum sealing facilitated by an autoclave. Additionally or alternatively, pressing can comprise applying pressure by means of pressing plates wherein the material stack is disposed therebetween and/or a roller moving across an outer surface of the material stack. Pressing can comprise a gravitational component according to the weight of each respective layer.

Additionally or alternatively to applying the primary conductive member, the secondary conductive member can be applied to the substrate. The secondary conductive member may also be applied to the substrate during a curing process. The secondary conductive member can be disposed on the top surface of the substrate, respectively the top layer. Bonding the secondary conductive member can be performed simultaneously to the bonding of the primary conductive member to the substrate. Thereto, the curing process can be performed, after the primary conductive member and the secondary conductive member are disposed on the substrate. The substrate, the top layer comprising the primary conductive member, and the secondary conductive member can form a material stack. The primary conductive member and the secondary conductive member can be conductively coupled, preferably during the bonding process, e.g., by applying heat and/or pressure.

The secondary conductive member can be a conductive foil, preferably a metal foil or metalized foil. Alternatively, the secondary conductive member can be formed from sheet metal or metalized sheet material. The secondary conductive member can be flexible. The secondary conductive member can comprise a carrier sheet configured to structurally support the secondary conductive member. Preferably, the secondary conductive member can be formed from a continuous solid material, i.e., without breaks, holes, and/or perforations. The primary conductive member can have a larger material thickness than the secondary conductive member. Preferably, the coper foil can have a thickness in the micrometer range, e.g., 10 µm - 500 µm. Preferably, a thickness below 300 µm. The method can comprise applying a surface treatment to the secondary conductive member, preferably to an application surface of the secondary conductive member facing the primary conductive member.

The surface treatment can include cleaning, etching, and/or applying a primer to improve adhesion. Preferably, the method can comprise growing surface structures, i.e., nanostructures, on the surface of the secondary conductive member. These nanostructures can improve the bonding between the secondary conductive member and primary conductive member, and/or the substrate. Specifically, the bonding of a resin of the substrate and/or top layer, with the primary conductive member and/or the secondary conductive member. Thereto, applying the secondary conductive member to the substrate can be performed before the top layer of the substrate is cured. Additionally or alternatively, an adhesive layer can be applied between the top layer, respectively the primary conductive member, and the secondary conductive member.

The method can comprise shaping the secondary conductive member according to a predetermined surface shape. This can maximize the shielding efficiency while reducing the amount of material applied.

The surface structured layer can be configured to increase a surface roughness, i.e. microscopic surface complexity, of the respective conductive member it is formed with, respectively formed on. The surface structured layer can be a separate element, formed with or formed on the primary conductive member and/or formed with or formed on the secondary conductive member. Thereto, references to a corresponding conductive member apply equally to the primary conductive member and the secondary conductive member.

The surface structured layer can comprise an extensive plane of wire-shaped elements integrally attached to the corresponding conductive member. The surface structured layer can comprise nanowires, e.g., form a carpet or lawn of nanowires on the surface of the corresponding conductive member. A nanowire can be defined as any material body that has a wire-like shape and a size ranging in the nanometer scale up to the micrometer scale.

The nanowires are preferably provided parallel to a surface normal of the secondary conductive member. The nanowires can be angled or interwoven while still having an orientation substantially parallel to the surface normal. Alternatively, the nanowires can be provided in any orientation.

Each wire structure can have a size in the range from a few nanometers to a few micrometers. A nanowire can have a symmetrical cross section. For example, the nanowires can generally be shaped circular, oval or have polygonal base, e.g., a hexagonal base. Preferably, the nanowires have a length in the range from 100 nm to 100 µm, in above 500 nm. The nanowires can have a diameter in the range from 10 nm to 10 µm, in particular below 2 µm. The nanowires can be produced from electrically conductive materials, e.g., metals, preferably copper or copper alloys. The nanowires can be grown galvanically on the surface of the corresponding conductive member. Thereto, the surface on which the nanowires are grown is preferably electrically conductive. The nanowires can be provided uniformly such that they are distributed evenly on the corresponding conductive member, respectively, that an area density of nanowires is constant over the corresponding conductive layer.

Depending on the material of the nanowires, the connection can have different properties. In particular, the mechanical strength and thermal conductivity of the connection are influenced by the material of the nanowires. The fact that the nanowires on the two connecting surfaces are made of different materials means that two connections with different properties can be formed. The connecting element can therefore also be regarded as a mediator between the two components to be connected in that two components that are otherwise not or only poorly connectable to each other can be connected to each other via the connecting element.

The surface structured layer can be positioned areal in the substrate, i.e., form a sheet like structure parallel to the top surface of the substrate. The surface structured layer can be extensively planar, specifically parallel to the top surface.

In a further example, the surface structured layer can be configured to cover a predetermined bonding surface completely. Preferably, a surface of the secondary conductive member facing the substrate can be fully covered in nanowires. The secondary conductive member may comprise handling tabs, i.e., surface segments at the edges of the secondary conductive member void of nanowires, e.g.., smooth copper.

With the method described, the secondary conductive member can be joined to the substrate, respectively the primary conductive member at a low temperature and/or under low pressure. In particular, the substrate may require compliance with predetermined temperature and pressure threshold limits, e.g., not exceeding a melting point of a composite material or maximum force applied to a surface of the substrate.

The stack components can be connected to each other via respective contact surfaces. A contact surface can be defined as a spatial area of a surface of the respective component. The contact surfaces can be characterized by the formation of a structural bond between the components. Referring to the primary conductive member and secondary conductive member the bond is preferably configured to establish a conductive path between the elements.

The surface structured layer can be considered as only being virtually separated from the primary conductive member respectively the secondary conductive member. In other words, a surface structure can be integrally formed on the primary conductive member and/or the secondary conductive member forming the surface structured layer that facilitates bonding of the secondary conductive member to the substrate. Thereto surface structure and preferably also an adhesive can come into contact with the respective component in the area of corresponding contact surfaces.

Due to the size of the surface structure in the nanometer range, the surface area of the connection can be particularly large. This can achieve the advantage of providing a bond with an increased electrical and/or thermal conductivity. The surface structure can also contribute to the mechanical stability of the connection. Bonding of the secondary conductive member can be achieved tool free, e.g., by stacking of the components only. In other words, in order to connect the contact surfaces via the surface structure, the contact surfaces to be connected can merely be brought together. Pressure can optionally be applied.

According to a further embodiment the method comprises the step of providing an adhesive layer at a bonding surface of the top layer. The surface structured layer can be configured to interlink with the adhesive layer during bonding of the secondary conductive member to the top layer. The adhesive layer can be a resin layer and/or an additional layer of the composite material forming the substrate. The adhesive layer can provide a matrix for the primary conductive member and the secondary conductive member to form a firm and conductive bond. The connection can be formed by applying the adhesive to one or both contact surfaces and also by bringing the two contact surfaces together. When the contact surfaces are brought together, they are therefore connected to each other both via the surface structured layer and via the adhesive layer.

The adhesive layer can be made from a polymer matrix, such as epoxy, polyester, or vinyl ester resin. The adhesive layer can achieve the advantage of ensuring strong adhesion between the composite material and the secondary conductive member, enhancing the overall structural integrity and performance of the composite.

The adhesive layer can be configured to maintain a structural configuration of the surface structure, e.g., an orientation of the nanowires, during bonding of the secondary conductive member to the substrate, respectively primary conductive member. Thereto, applying the adhesive layer can comprise disposing the adhesive on the contact surface, in particular in such a way that the nanowires maintain the perpendicular arrangement after the bonding is completed, e.g., after the adhesive in contact with the secondary conductive member is cured. In other words, the nanowires may not be tilted when the adhesive is applied. This can be achieved, for example, by using a sufficiently low-viscosity adhesive configured to exert correspondingly low forces on the surface structure during application. The adhesive layer and the surface structured layer can be provided on the same surface. The adhesive can be present in gaps of the surface structure, e.g., between the nanowires, before the secondary conductive member is disposed on the substrate, thereby stabilizing the surface structure.

The method can comprise immersing the surface structure in the adhesive layer. Preferably, end elements of the surface structure protrude from the adhesive layer to contact the corresponding contact surface. For example, the surface structure may still contact the primary conductive member, respectively the substrate when it is formed on the secondary conductive member and the adhesive layer is present on the secondary conductive member. Additionally, or alternatively, the surface structure can penetrate an adhesive layer present on the substrate, respectively the primary conductive member to contact the primary conductive member.

According to a further embodiment the primary conductive member and the secondary conductive member connect conductively during bonding of the secondary conductive member to the substrate. Connecting the secondary conductive member to the substrate, i.e., the top layer, respectively the primary conductive member can refer to the process of establishing a physical link between the surface structured layer and the top layer. This can involve bringing the two surfaces into intimate contact, preferably under pressure and with or without the application of heat. The atomic forces at the interface can create a bond, resulting in a seamless connection.

Further, connecting can relate to interlinking which describes the formation of a continuous and integrated interface between the surface structured layer and the top layer. This can involve the alignment and interaction of atomic or molecular structures at the surfaces, leading to a strong, cohesive bond. The interlinking process can ensure that the mechanical and physical properties of the two materials are effectively combined.

Also, connecting can relate to attaching the secondary conductive member via the surface structured layer. This can comprise applying pressure that causes plastic deformation at the contact surface. The deformation can allow the atoms from both surfaces to come close enough to form metallic bonds, resulting in a robust attachment. The method can comprise annealing of the material stack, respectively the bond between substrate, primary conductive member, and secondary conductive member, to relieve residual stresses and enhance the bond strength.

According to a further beneficial embodiment providing the surface structured layer can comprise the step of forming the surface structured layer integrally with the primary conductive member. This can achieve the advantage that the primary conductive member and the surface structured layer form a single body. The surface structure can be created galvanically such that the structure grows on the primary conductive member. The primary conductive member may provide a base conductivity, respectively a base shielding, which can be enhanced by additionally providing the secondary conductive member. Thereto, the surface structured layer can be applied locally confined to the primary conductive member. Preferably, areas designated to receive the secondary conductive member can be provided with the surface structured layer. Thus, the surface structured layer, respectively, the process of growing the surface structured layer can be applied locally to the primary conductive member. This can also achieve the advantage that the surface structured layer is embedded in the composite structure, e.g., resin of the substrate. Areas for growing the surface structure can be defined by applying a lithographic process to the primary conductive member which prepares predetermined areas for structure application, respectively nanowire growth.

According to a further beneficial embodiment providing the surface structured layer can comprise the step of forming the surface structured layer integrally with the secondary conductive member. This can achieve the advantage that the primary conductive member and the surface structured layer form a single body. Advantageously, the second conductive layer can be prepared with the surface structure prior to applying the secondary conductive member to the substrate respectively the primary conductive member. The surface structured layer can be formed integrally on the complete surface of the secondary conductive member to seamlessly bond the secondary conductive member to the substrate. The method can comprise applying the secondary conductive member to a predetermined application area of the substrate. Preferably, the surface area of the predetermined application area is smaller than a surface area of the substrate, respectively an area covered by the primary conductive member.

The surface structure can be created galvanically such that the structure grows on the secondary conductive member. The secondary conductive member may have a higher shielding efficiency that the primary conductive member. The surface structured layer can be applied locally to predetermined enforcement areas to selectively increase the bond strength to the substrate, respectively the primary conductive member. Thus, the surface structured layer, respectively, the process of growing the surface structured layer can be applied locally to predetermined enforcement areas of the secondary conductive member. Areas for growing the surface structure can be defined by applying a lithographic process to the secondary conductive member which prepares predetermined areas for structure application, respectively nanowire growth.

According to a further embodiment, the method can comprise the step of providing a further surface structured layer facing the surface structured layer. The further surface structured layer can be formed on the primary conductive member, preferably on a surface facing the secondary conductive member, when the surface structured layer is formed on the secondary conductive member. Alternatively, the further surface structured layer can be formed on the secondary conductive member, preferably on a surface facing the primary conductive member, when the nanowire layer is formed on the primary conductive member. This achieves the advantage that a surface structure is present on the primary conductive member as well as on the secondary conductive member.

The connection between the primary conductive member and the secondary conductive member can be formed by the surface structured layer interacting with the further surface structured layer. In particular ends of the nanowires facing the respective contact surface can bond with the contact surface, respectively the corresponding surface structured layer. This bond can be formed at the atomic level and can be similar to a sintering process. Preferably, the resulting connection can achieve a level of impermeability to fluids that corrosion of the connection and/or the interconnected components in the area of the connection can be prevented or at least limited. Preferably, the formed joint can be considered to be fully metallic. The connection can be obtained by a plurality of nanowires and thus by a plurality of elongated, hair-like structures, in particular in combination with applying pressure and/or heat. The surface structured layer and/or the further surface structured layer can form a buffer zone configured to equalize surface unevenness and/or roughness of the contact surfaces of the primary conductive member and/or the secondary conductive member.

The further surface structured layer facing the surface structured layer can be defined as providing the further surface structured layer parallel to the surface of the surface structured layer. Specifically, the further surface structured layer can be adjacent to the surface structured layer such that the surface structured layer and the further surface structured layer form a single contact surface when joined together.

In a further embodiment, the method can comprise the step of providing a bottom surface structured layer on the primary conductive member facing away from the secondary conductive member. The method can further comprise the step of providing a top surface structured layer on the secondary conductive member facing away from the substrate. This can achieve the advantage that in particular in addition to a surface structured layer between the primary conductive member and the secondary conductive member an additional surface structured layer can be formed between the primary conductive member and the substrate and/or on top of the primary conductive member. The bottom surface structured layer can increase a bonding strength of the primary conductive member with the substrate. The top surface structured layer can increase a bond to any type of top layer, e.g., an outer coating, composite layer, further adhesive layer, and/or paint layer. Preferably, the surface structure can be provided on all bonding surfaces of the primary conductive member and/or the secondary conductive member. A bonding surface can be defined as being configured to attach to another sheet of material in the material stack in a stacking direction.

According to a further beneficial embodiment, bonding the secondary conductive member to the primary conductive member can comprise the step of applying a pressure to the secondary conductive member, in particular by means of vacuum sealing the stack consisting of the substrate and the secondary conductive member.

This can achieve the advantage that the substrate and/or the primary conductive member can be firmly bonded to the secondary conductive member. Specifically, an adhesion of the secondary conductive member to the substrate can require a specific pressure. Additionally, the pressure can facilitate a material bond between the primary conductive member and the secondary conductive member such that the primary conductive member and the secondary conductive member form an integral connection providing a homogenous bond.

The pressure can also allow the secondary conductive member to penetrate an optional adhesive layer to contact the primary conductive member. The process can be gravity assisted based on to the weight of the substrate.

According to another embodiment, applying a pressure to the secondary conductive member can comprise disposing the material stack on a tooling platform, wherein the secondary conductive layer is facing towards the tooling platform, and vacuum sealing the material stack to the tooling platform to press the material stack onto the tooling platform increasing the pressure between the primary conductive member and the secondary conductive member.

The stack can be formed in single layers on the tooling platform or can be disposed as a preformed stack on the tooling platform. Forming the stack on the tooling platform can comprise disposing the secondary conductive member on a tooling platform; disposing the primary conductive member, i.e., the top layer, on top of the secondary conductive member; disposing the substrate on top of the primary conductive member.

The primary conductive member can be either dry or pre-impregnated with resin. When pre-impregnated, the resin may increase the structural integrity of the primary conductive member, providing additional strength and stability during the stacking and bonding process.

Next, the substrate, e.g., composite prepreg plies, can be disposed over the primary conductive member. Once the material stack is prepared, a vacuum bag can be placed over the entire stack. The vacuum bag can be a flexible membrane that is sealed to the tooling platform to create an airtight enclosure. Air is then evacuated from the vacuum bag, creating a vacuum environment. This vacuum can apply uniform pressure across the material stack, ensuring proper consolidation and bonding of the layers.

The consolidated material stack can then be subjected to a curing process, preferably in an autoclave. The autoclave can be configured to provide a pressure and temperature controlled environment suitable to cure the composite materials with a predetermined temperature and/or pressure, respectively a temperature profile and/or pressure profile providing varying temperature respectively pressure. A typical consolidation temperature can be approximately 180°C. Temperature and/or pressure can depend on the specific resin system. The pressure treatment in the autoclave can eliminate or at least reduce voids and/or porosity.

The disclosed method provides the advantage of being able to strategically place the secondary conductive member, the primary conductive member, and composite prepreg plies in relation to one another, followed by a pressure and/or temperature curing. Uniform pressure application and optimal consolidation can be ensured, providing composite structures suitable for aerospace applications.

In a further embodiment, the method can comprise disposing an additional composite layer on the tooling platform prior to disposing the secondary conductive member. The secondary conductive member can then be disposed on the additional composite layer. Thereto, the additional composite layer can form an outer layer of the material stack. This can increase the robustness of the stack and/or protect the secondary conductive member from the environment.

According to a further embodiment, applying the pressure can comprise disposing the material stack on a tooling platform with the secondary conductive layer facing away from the tooling platform, and/or vacuum sealing the material stack to the tooling platform to press the material stack onto the tooling platform increasing the pressure between the primary conductive member and the secondary conductive member.

The disclosed method can be extended to composite repair processes. Specifically, the method can comprise attaching the secondary conductive member to a substrate, e.g., composite structure, which may have undergone mechanical treatments, such as milling, during the repair process. The secondary conductive member can be affixed to the substrate using an adhesive, e.g., a two-component adhesive. To ensure uniform adhesive distribution and maintain a consistent bond line thickness between the composite parts and the secondary conductive member. Applying the surface structured layer can improve bonding and structural integrity in composite repairs.

According to a further embodiment, the method can comprise providing a distance mesh layer between the primary conductive member and the secondary conductive member. The distance mesh layer can be a fabric type material. It can be inserted between the substrate and the secondary conductive member to provide a uniform distance between the primary conductive member and the secondary conductive member. The distance mesh layer can be compressible.

According to another embodiment, providing the substrate can comprise forming the top layer at a top surface of the substrate, forming the surface structure layer on the primary conductive member; and embedding the primary conductive member in the top layer such that the primary conductive member bonds to the top layer by means of the surface structure. Thereby the advantage can be achieved that a bond between the primary conductive member and the substrate, respectively the top layer can be increased. The surface structured layer can face towards the substrate or face towards the secondary conductive member.

According to a further aspect the present disclosure relates to a conductive component comprising a substrate having a top layer. The top layer can comprise a primary conductive member, preferably disposed at a top surface of top layer. The conductive component can comprise a secondary conductive layer element disposed on the top layer, e.g., contacting the top surface. Further, the conductive component can comprise a surface structured layer disposed between the primary conductive member and the secondary conductive member. The secondary conductive layer element can be materially bonded to the top layer and conductively connected to the primary conductive member. The surface structured layer can primarily increase the bonding strength between the corresponding conductive member and a resin, respectively adhesive layer and may facilitate an electrical connection between the conductive members. Additionally or alternatively, the surface structured layer can facilitate a material bond between the conductive members, in particular so that a continuous homogenous metallic bond is formed between the conductive members.

In a further embodiment, the conductive component can comprise an adhesive layer between the primary conductive layer and the secondary conductive layer, wherein the adhesive layer is configured to interlink with the surface structured layer. The adhesive layer can serve as an embedding for the surface structured layer. The increased surface area of the surface structured layer can provide increased bonding strength when contacting, respectively curing the adhesive layer. Further, the adhesive layer can provide structural support to the surface structured layer.

In another embodiment, the surface structured layer is integrally formed with at least one of the primary conductive member and the secondary conductive member. The surface structured layer can be initially formed on one of the conductive members and during a bonding process the surface structured layer can be materially bonded to the remaining conductive member.

### BRIEF DESCRIPTION OF THE DRAWINGS

The subject matter will hereinafter be described in conjunction with the following drawing figures, wherein like numerals denote like elements, and wherein:
Fig. 1 is a schematic representation of a material stack on a tooling platform in accordance with an embodiment of the invention;
Fig. 2 is a further schematic representation of a material stack on a tooling platform in accordance with an embodiment of the invention;
Fig. 3 is a schematic representation of the conductive member in accordance with an embodiment of the invention;
Fig. 4 is a further schematic representation of the conductive member in accordance with an embodiment of the invention;
Fig. 5 is yet another schematic representation of the conductive member in accordance with an embodiment of the invention;
Fig. 6 is an additional schematic representation of the conductive member in accordance with an embodiment of the invention;
Fig. 7 is yet a further schematic representation of the conductive member in accordance with an embodiment of the invention;
Fig. 8 is a schematic representation of the method in accordance with an embodiment of the invention;

### DETAILED DESCRIPTION OF THE DRAWINGS

The following detailed description is merely exemplary in nature and is not intended to limit the invention and uses of the invention. Furthermore, there is no intention to be bound by any theory presented in the preceding background or the following detailed description.

The representations and illustrations in the drawings are schematic and not to scale. Like numerals denote like elements.

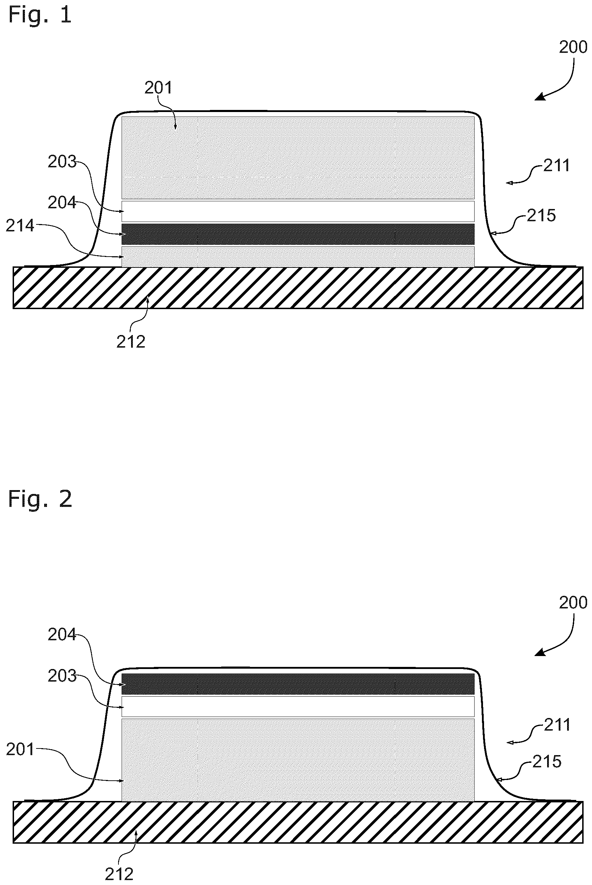

Fig. 1 depicts the material stack 211 forming the conductive component 200 on a tooling platform 212. The tooling platform 212 can be configured to provide a vacuum in conjunction with the vacuum bag 215. The conductive component can comprise an outer layer 214 configured to limit the conductive component 200. The out layer 214 can protect the secondary conductive member 204 during the bonding phase on the tooling platform 212 and/or in use of the conductive component 200. By applying a vacuum a compression force can be exerted onto the material stack 211 pressing the material stack 211 onto the tooling platform 212. Thereto a specific pressure to bond the secondary conductive member 204 to the primary conductive member 203, respectively the top layer, can be provided. The displayed stacking order of the components can be a beneficial embodiment during manufacturing of the conductive component 200. The substrate 201 can transfer the force applied by the vacuum bag 215 to the primary conductive member 203 and the secondary conductive member 204.

Fig. 2 depicts a further embodiment of the material stack 211 according to the invention. Thereto, the material stack 211 comprises the substrate 201, the primary conductive member 203, and the secondary conductive member 204. The primary conductive member can be embedded in a top layer of the substrate 201. This stack order can be beneficial for repair, maintenance and/or resurfacing applications. For example, a previously produced conductive component 200 can be reinforced, upgraded and/or patched by applying the secondary conductive member 204. For example a defect in the primary conductive member 203 can be covered by the secondary conductive member 204. In the shown configuration, the vacuum bag 215 is disposed on the secondary conductive member 204 such that the force is directly applied to the secondary conductive member 204. Based on the generated pressure by forming a vacuum, the secondary conductive member 204 can be bonded to the primary conductive member 203, respectively the top layer of the substrate 201.

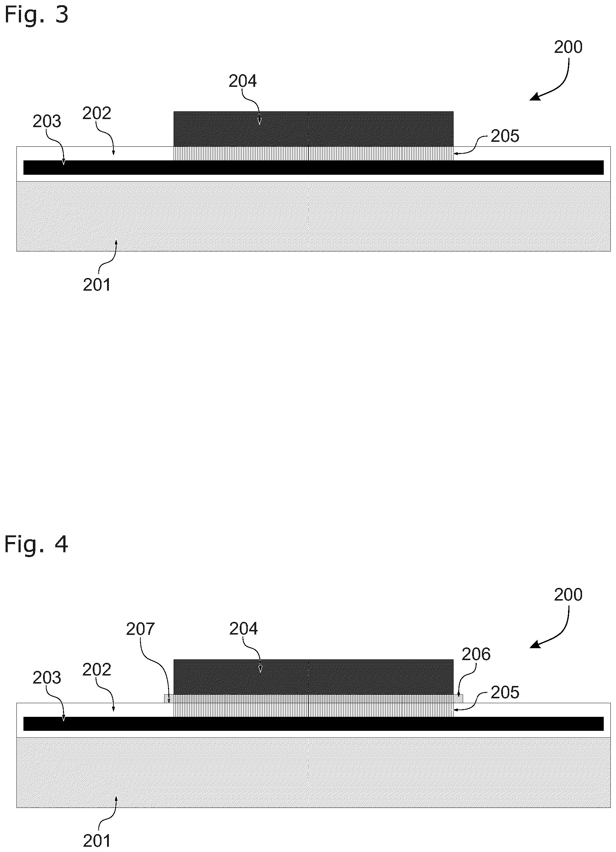

Fig. 3 depicts a schematic representation of an embodiment of the conductive member 200. The primary conductive member 203 can be embedded in the top layer 202 of the substrate 201. Thereto, the primary conductive member 203 can form the top layer 202. Specifically, when the primary conductive member 203 is combined with resin, adhesive and/or other bonding materials to adhere the primary conductive member 203 to the substrate 202. The secondary conductive member 204 can be disposed locally on a bonding surface of the top layer 202, i.e., the secondary conductive member 204 may not cover the complete top layer 202. The surface structured layer 205 can be formed integrally on a bottom surface of the secondary conductive member 204. Specifically, the surface structured layer 205 can be galvanically grown on the secondary conductive member 204. Advantageously generating the surface structured layer 205 is performed before applying the secondary conductive member 204 to the top layer 202. The surface structured layer 205 may increase the bonding strength of the secondary conductive member 204 to the top layer. Thereto, the surface structured layer 204 may not necessarily increase a bond between the primary conductive member 203 and the secondary conductive member 204 but may primarily increase a bonding strength of the secondary conductive member 204 to a matrix, resin and/or adhesive of the top layer 202. Preferably, the surface structured layer 204 facilitates an electrical contact between the primary conductive member 203 and the secondary conductive member 204. The electrical contact can be established during bonding and preferably can be permanent.

Fig. 4 depicts a schematic representation of a further embodiment of the conductive component 200. In addition to the substrate 201, the primary conductive member 203 in the top layer 202, the surface structured layer 205 and the secondary conductive member 204, the material stack forming the conductive component 200 comprises an adhesive layer 206. The adhesive layer 206 can be disposed on a bonding surface 207 of the top layer 202. The adhesive layer can be configured to adhere the secondary conductive member 204 to the top layer 202. The adhesive layer can further be configured to stabilize the surface structured layer 205 during bonding. Thereto, the surface structured layer 205 can be integrally formed with the secondary conductive member 204 and the adhesive layer can be applied to the surface structured layer 205 prior to disposing the secondary conductive member 204with the surface structured layer 205 facing the bonding surface 207 on the bonding surface 207. The adhesive layer 206 can further bond to the primary conductive member 203 to bond the secondary conductive member 204 to the primary conductive member 203.

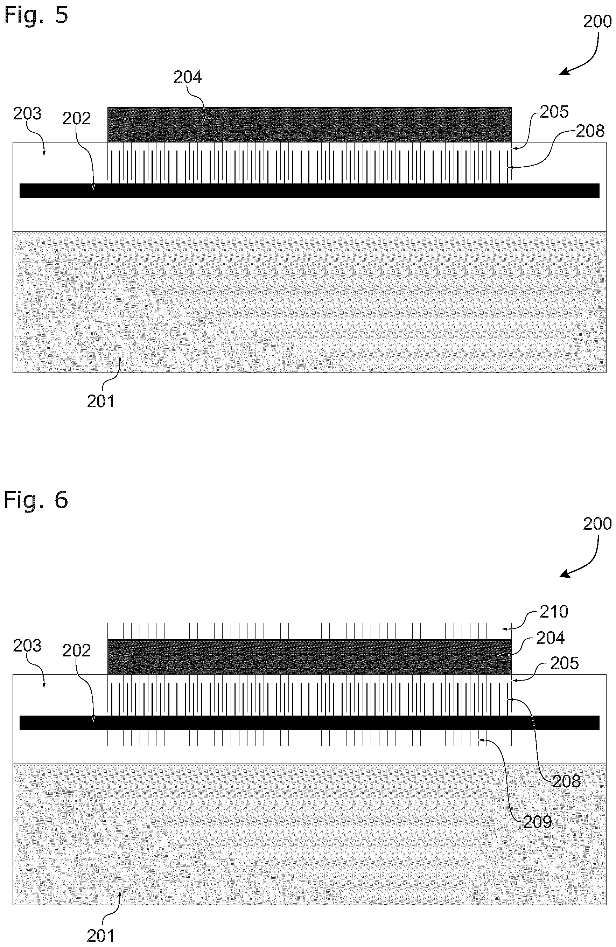

Fig. 5 depicts a schematic representation of a further embodiment of the conductive component 200. The surface structured layer 205 is formed on the secondary conductive member 204 and a further surface structured layer 208 is formed on the primary conductive member 202. The surface structured layer 205 and the further surface structured layer 208 can be interlinked, preferably forming a welding like bond, i.e., cold welding. The interleaving can be organized, e.g., interleaved alternating strands, or amorphous, e.g., the strands form a chaotically interleaved layer. The bond between the surface structured layers 205 and 208 can be supported by an adhesive, resin and/or other composite materials being present between the surface structured layer 205, 208, respectively immersed in the surface structured layers 205, 208. Further, the surface structured layers 205, 208 can be deformed, e.g., partially deformed due to the bonding process where the surface structured layers 205, 208 can be pressed against each other. The surface structured layers 205, 208 may form a connected layer such that end tips of the corresponding strands may not touch the corresponding surface structured layer and connecting conductively respectively bonding is achieved via the connected layer. Alternatively, each or only one of the surface structured layers may connect to the corresponding conductive member directly.

Fig. 6 depicts a schematic representation of a further embodiment of the conductive component 200. In addition to features according to the embodiment shown in Fig. 5, the primary conductive member 202 can comprise a bottom surface structured layer 209 configured to attach the primary conductive member 202 to the top layer 203, respectively the substrate 201. The bottom surface structured layer 209 can increase a bonding strength of a bond between the primary conductive member 204 and the top layer 203, respectively the substrate 201 in particular by increasing a surface area in contact with a resin or adhesive. Additionally or alternatively, the secondary conductive member 204 can comprise a top surface structured layer 210. This layer can be configured to increase a bond of the secondary conductive member 204 to any layer placed on top of it. For example, an outer composite layer can be attached to the secondary conductive member 204 by means of the top surface structured layer 210.

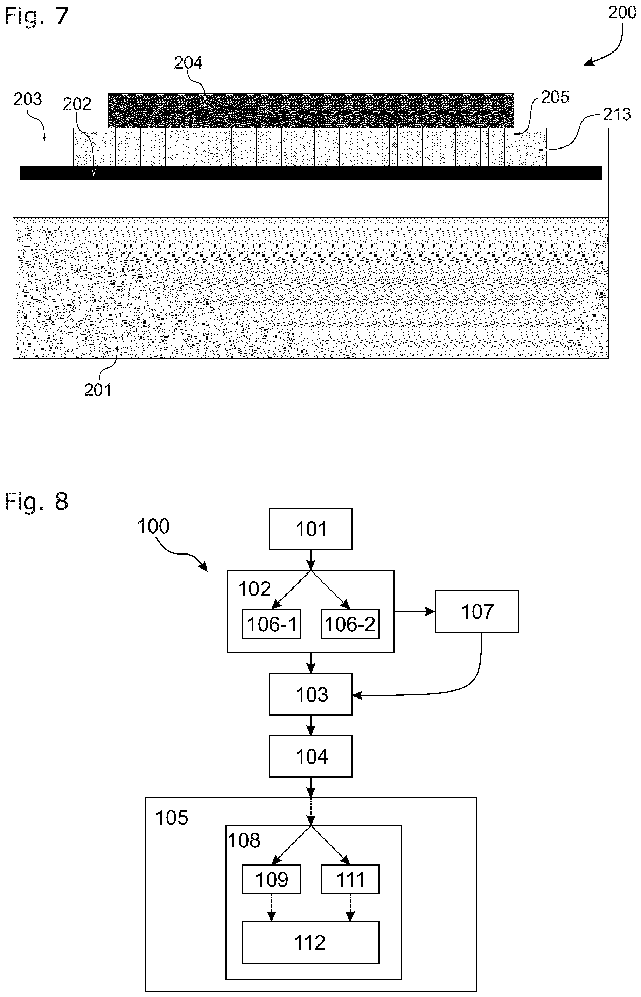

Fig. 7 depicts a schematic representation of a further embodiment of the conductive component 200. In addition to features according to the embodiment shown in Fig. 3, the conductive component 200 can comprise a distance mesh layer 213. Incorporating a distance mesh layer 213 positioned between the primary and secondary conductive members 202, 204 can ensure a consistent separation between the primary and secondary conductive members 202, 204. Additionally, the distance mesh layer 213 may possess compressible properties to enable the conductive layers 202, 204 to form a bond and/or contact. The distance mesh layer 213 can be integrated with the surface structured layer 205. Thereto, a specific height of non-deformed and/or non-compressed surface structure can be achieved. Further, the distance mesh layer can be configured to protect the surface structured layer 205 against plastic deformation. The distance mesh layer can be provided as part of an adhesive or resin layer between the conductive members 202, 204.

Fig. 8 depicts a schematic representation of the method for providing a conductive component, respectively of manufacturing a conductive component. The method may begin with providing 101 a substrate that includes a top layer with a primary conductive member. A surface structured layer can be provided 102 between the primary and secondary conductive members. Next, the secondary conductive member can be provided 103 on the top layer. The secondary conductive member is then bonded 105 to the top layer, i.e., the primary conductive member, using the surface structured layer, ensuring a solid connection and conductive coupling between the primary and secondary conductive members.

Additionally, an adhesive can be provided 104 at the bonding surface of the top layer, such that the surface structured layer interlinks with the adhesive during the bonding process.

The method may include forming 106-1 the surface structured layer integrally with the primary conductive member or forming 106-2 it integrally with the secondary conductive member. A further surface structured layer can be provided 107 facing the initial surface structured layer, depending on which conductive member the initial layer is formed.

The bonding process can involve applying 108 pressure to the secondary conductive member by vacuum sealing a material stack consisting of the substrate and the secondary conductive member. This pressure application can be done by disposing 109 the material stack on a tooling platform with the secondary conductive member facing towards the platform and vacuum sealing 112 it to increase the pressure between the conductive members. Alternatively, the material stack can be disposed 111 on the tooling platform with the secondary conductive member facing away from the tooling platform.

## Claims

1. Method (100) for bonding a conductive member toa substrate providing a conductive path in aircraft components, comprising the steps of:
providing (101) a substrate (201) comprising a top layer (202) with a primary conductive member (203);
providing (103) a secondary conductive member (204) on the top layer(202);
providing (102) a surface structured layer (205) between the primary conductive member (203) and the secondary conductive member;
bonding (105) the secondary conductive member (204) to the top layer (202) by means of the surface structured layer (205) to conductively couple the primary conductive member (203) and the secondary conductive member (204).

2. Method (100) according to claim 1, comprising the step of:
Providing (104) an adhesive (206) at a bonding surface (207) of the top layer (202), wherein the surface structured layer (205) interlinks with the adhesive (206) during bonding (105) of the secondary conductive member (204) to the top layer (202).

3. Method (100) according to any one of the preceding claims, wherein the primary conductive member (203) and the secondary conductive member (204) connect conductively during bonding (105) of the secondary conductive member (204) to the top layer (202).

4. Method (100) according to any one of the preceding claims, wherein providing (102) the surface structured layer comprises forming (106-1) the surface structured layer (205) integrally with the primary conductive member(203).

5. Method (100) according to any one of claims 1 to 3, wherein providing the surface structured layer (205) comprises forming (106-2) the surface structured layer (205) integrally with the secondary conductive member (204).

6. Method (100) according to any one of the preceding claims, comprising the step of:
providing (107) a further surface structured layer(208) facing the surface structured layer (205),
wherein the further surface structured layer is formed on the primary conductive member(203), when the surface structured layer (205) is formed on the secondary conductive member (204), and
wherein the further surface structured layer (208) is formed on the secondary conductive member (204), when the surface structured layer (205) is formed on the primary conductive member (203).

7. Method (100) according to any one of the preceding claims, comprising the step of:
providing a bottom surface structured layer (209) on the primary conductive member (203) facing away from the secondary conductive member(204); and
providing a top surface structured layer (210) on the secondary conductive member (204) facing away from the substrate (201).

8. Method (100) according to any one of the preceding claims, wherein bonding (105) the secondary conductive member (204) to the primary conductive member (203) comprises the step of:
applying (108) a pressure to the secondary conductive member (204) by means of vacuum sealing a material stack (211) consisting of the substrate (201) and the secondary conductive member (204).

9. Method (100) according to claim 8, wherein applying (108) a pressure comprises:
disposing (109) the material stack on a tooling platform (212), wherein the secondary conductive member (204) is facing towards the tooling platform (212);
and
vacuum sealing (112) the material stack to the tooling platform to press the material stack onto the tooling platform increasing the pressure between the primary conductive member (203) and the secondary conductive member (204).

10. Method (100) according to any one of the claims 1 to 8, wherein applying (108) a pressure comprises:
disposing (111) the material stack (211) on a tooling platform (212) with the secondary conductive member (204) facing away from the tooling platform (212); and
vacuum sealing (112) the material stack(211) to the tooling platform (212) to press the material stack (211) onto the tooling platform (212) increasing the pressure between the primary conductive member (203) and the secondary conductive member (204).

11. Method (100) according to any one of the preceding claims comprising the step of:
providing a distance mesh layer (213) between the primary conductive member and (203) the secondary conductive member (204).

12. Method (100) according to any one of the preceding claims, wherein providing (101) the substrate (201) comprises:
forming the top layer (203) at a top surface of the substrate (201);
forming the surface structure layer (205) on the primary conductive member (203); and
embedding the primary shielding (203) element in the top layer (202) such that the primary conductive member (203) bonds to the top layer (202) by means of the surface structure (205).

13. Conductive component (200), comprising:
a substrate (201) having a top layer (202);
wherein the top layer (202) comprises a primary conductive member (203);
a secondary conductive member (204) disposed on the top layer (202);
a surface structured layer (205) disposed between the primary conductive member (203) and the secondary shielding element (204), wherein the secondary conductive member (204) is materially bonded to the top layer (202) and conductively connected to the primary conductive member (203).

14. Conductive component (200) according to claim 13, comprising
an adhesive layer (206) disposed between the primary conductive member (203) and the secondary conductive member (204), wherein the adhesive layer (206) is configured to interlink with the surface structured layer (205).

15. Conductive component (200) according to claim 13, wherein the surface structured layer (205) is integrally formed with at least one of the primary conductive member (203) and the secondary conductive member (204).
